# FASCICULE DE BREVET EUROPEEN

(11) **EP 0 584 087 B1**
(45) Date de publication et mention de la délivrance du brevet: **08.03.2000**
(21) Numéro de dépôt: 92907297.3
(22) Date de dépôt: 28.02.1992
(51) Int. Cl.: G01R 31/02, G01R 31/28

(54) **CIRCUIT DE TEST INTEGRE POUR DISPOSITIFS D'AFFICHAGE TELS QUE DES AFFICHEURS A CRISTAUX LIQUIDES**
INTEGRIERTE TESTSCHALTUNG FÜR ANZEIGEGERÄTE WIE FLÜSSIGKEITSKRISTALLANZEIGEGERÄTE
INTEGRATED TEST CIRCUIT FOR DISPLAY DEVICES SUCH AS LIQUID CRISTAL DISPLAYS

(30) Priorité: 28.02.1991 US 660275
(43) Date de publication de la demande: 02.03.1994
(73) Titulaire: THOMSON-LCD, 92800 Puteaux (FR)
(72) Inventeur: PLUS, Dora, F-92045 Paris-La Défense Cédex 67 (FR); MOUREY, Bruno, F-92045 Paris-La Défense Cédex 67 (FR)
(74) Mandataire: Ruellan-Lemonnier, Brigitte
(86) Numéro de dépôt international: FR9200188
(87) Numéro de publication internationale: WO9215891

(56) Documents cités:
- EP-A- 0 143 039
- GB-A- 2 081 018
- US-A- 4 893 311
- SID INTERNATIONAL SYMPOSIUM, DIGEST OF TECHNICAL PAPERS 16 Mai 1989, BALTIMORE, MARYLAND, USA pages 238 - 241; Y. MATSUEDA ET AL.: 'Defect-Free Active Matrix LCD with Redundant Poly-Si TFT Circuit'

## Description

La présente invention concerne un circuit de test intégré pour dispositifs d'affichage, en particulier pour afficheurs à cristaux liquides.

Les afficheurs à cristaux liquides pour la télévision et les ordinateurs sont connus dans la technique. On peut par exemple, se référer aux brevets américains 4.742.346 et 4.766.430, tous deux accordés à G.G.Gillette et al. et pris ici comme référence.

Les afficheurs du type décrit dans les brevets Gillette comprennent une matrice de cellules à cristaux liquides qui sont disposées aux croisements de lignes de données et de lignes de sélection. Les lignes de sélection sont sélectionnées en séquence par un balayeur de lignes de sélection pour produire les lignes horizontales de l'afficheur. Les lignes de données appliquent les signaux de brillance (échelle de gris) aux colonnes de cellules à cristaux liquides lorsque les lignes de sélection sont sélectionnées en séquence. Chaque cellule à cristal liquide est associée à un dispositif de commutation par lequel une tension en forme de rampe est appliquée aux cellules à cristaux liquides dans la ligne sélectionnée. Chacun des dispositifs de commutation est maintenu par un comparateur, ou un compteur, qui reçoit un des signaux de brillance pour permettre à la tension en forme de rampe de charger la cellule à cristal liquide associée à une tension proportionnelle au niveau de brillance reçu de la ligne de données par le comparateur.

Les afficheurs à cristaux liquides pour télévision et moniteurs d'ordinateurs ont de nombreuses colonnes de cellules à cristaux liquides, par exemple 1.440. En supposant des cellules à cristaux liquides sensiblement carrées et un format d'image de télévision standard de 4x3, un afficheur avec 1.440 lignes de données aurait environ 1.080 lignes de sélection. Dans un afficheur acceptable, aucune parmi ce grand nombre de lignes ne peut inclure d'ouverture. Aussi, les lignes de données et les lignes de sélection sont perpendiculaires et donc se croisent les unes les autres et doivent être isolées électriquement. Trois types de défaillance se produisent fréquemment pendant la fabrication des afficheurs à LCD, à savoir la défaillance des étages de balayage des lignes de données, la coupure des lignes de données et les courts-circuits entre lignes de sélection et lignes de données. Pour cette raison, on a besoin d'un circuit pour tester de tels défauts qui soit fiable, rapide et peu coûteux. La présente invention satisfait ce besoin en fournissant un circuit intégré qui est fabriqué sur le substrat du dispositif d'affichage et qui réduit sensiblement le nombre de lignes de test nécessaires pour le dispositif d'affichage.

La présente invention peut être utilisée avec l'invention décrite dans la demande de brevet S/N 660274 déposée en même temps que la présente par Antoine Dupont et Dora Plus et intitulée "Registres à décalage redondants pour dispositifs de balayage".

La présente invention peut être utilisée avec l'invention décrite dans la demande de brevet S/N 660273 déposée en même temps que la présente par Dora Plus et Antoine Dupont et intitulée "Conception et Méthodologie de test pour registres à décalage redondants".

Un circuit de test pour tester la continuité des lignes de données d'un afficheur à cristaux liquides, pour tester les étages d'un balayeur de lignes de données, et pour détecter des court-circuits entre les lignes de données et les lignes de sélection de l'afficheur, comprend un bus de sortie avec une ligne de test. Une pluralité de TFT (pour transistor en couche mince) connectant séparément les lignes de données au bus de sortie. Un registre à décalage actionne en séquence les électrodes de commande des TFT pour transférer les signaux de données des lignes de données à la ligne de test. La ligne de test est surveillée pour identifier les étages défectueux du balayeur de lignes de données, les lignes de données ouvertes et la ligne de sélection avec des lignes de données.

Le document SID INTERNATIONAL SYMPOSIUM, DIGEST OF TECHNICAL PAPES, 16 Mai 1989, BALTIMORE, MARYLAND USA pages 238 - 241; Y. MATSUEDA ET AL.: "Defect-Free Active Matrix LCD with Redundant Poly-Si TFT Circuit" ne concerne pas un circuit de test spécifique, mais un afficheur à cristaux liquides de structure spécifique permettant de réaliser un certain nombre de tests à l'aide des drivers.

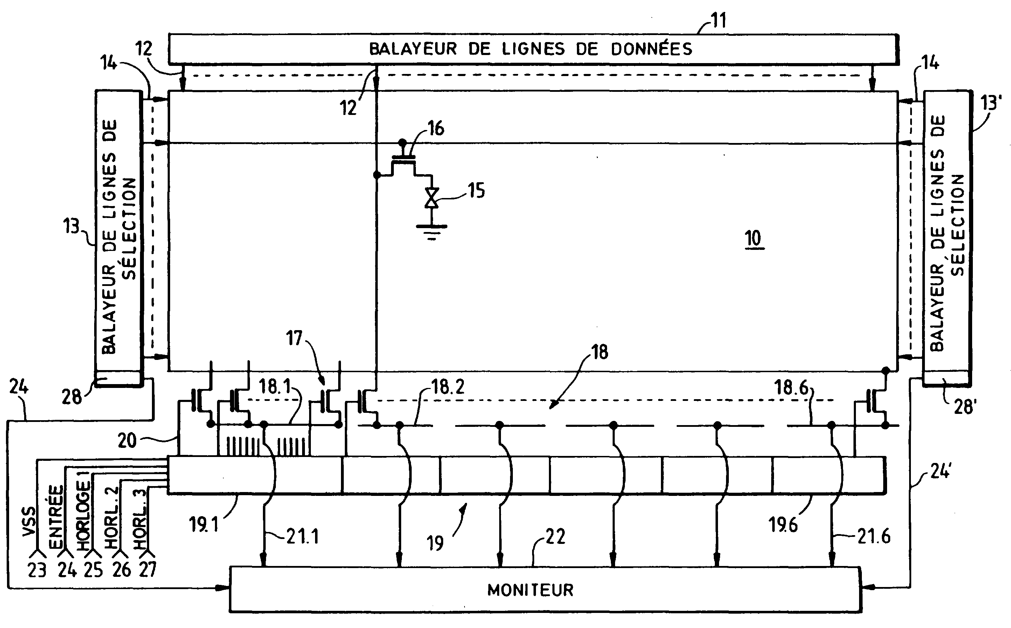

La Figure représente un mode de réalisation préférentiel.

Sur la Figure, un afficheur à cristaux liquides 10 comprend un balayeur 11 de lignes de données qui fournit des signaux de données sur une pluralité de lignes de données 12. Un balayeur 13 de lignes de sélection applique séquentiellement une tension sur une pluralité de lignes de sélection 14. Les lignes de données 12 et les lignes de sélection 14 sont perpendiculaires et les cellules à cristaux liquides, comme 15, sont disposées aux croisements. Des dispositifs de commutation 16, tels que des transistors à couches minces (TFT) sont mis sous tension par les lignes de sélection polarisées 14 et les lignes de données 12 chargent les cellules à cristaux liquides à des niveaux déterminés par les signaux de données. Un balayeur 13 de lignes de sélection redondant peut aussi appliquer une tension aux lignes de sélection 14. Les étages du balayeur 13 de lignes de sélection qui correspondent aux étages défectueux du balayeur 13 de lignes de sélection sont utilisés à la place des étages défectueux.

Trois types de défauts se produisent souvent pendant la fabrication des afficheurs à cristaux liquides, à savoir étages du balayeur de lignes de données défectueux, lignes de données ouvertes et lignes de sélection en court-circuite avec des lignes de données aux niveau de croisements. La présence d'un de ces défauts peut entraîner le rejet de l'afficheur. Cependant beaucoup de ces défauts peuvent être corrigés s'il existe la possibilité de les détecter et de les situer. La présente invention offre cette possibilité.

Le balayeur 11 de lignes de données, le balayeur 13 de lignes de sélection et les TFT 16 sont fabriqués simultanément sur un substrat isolant. Avec l'invention, des transistors de test 17, qui sont de préférence des TFT, sont fabriqués sur le substrat en même temps que les balayeurs 11, 13 et les TFT 16. La liaison conductrice d'un TFT 17 est disposée entre chacune des lignes de données 12 et un bus de sortie 18. Dans le mode de réalisation préférentiel représenté , le bus de sortie 18 est divisé en 6 parties, 18-1 à 18-6. Un registre à décalage 19 comprend de préférence un nombre de parties 19-1 à 19-6, égal au nombre de parties dans le bus de sorties 18. Les lignes de sortie 20 du registre à décalage 19 sont connectées séparément aux électrodes de commande des TFT 17. Des lignes de test 21-1 à 21-6 relient les parties 18-1 à 18-6 du bus, respectivement, à un moniteur 22. Les lignes d'entrée 23 à 27 sont utilisées pour fournir la tension de polarisation, le signal d'entrée et les signaux d'horloge du registre à décalage 19. La vitesse de fonctionnement du registre à décalage 19 est augmentée, et la charge du balayeur 11 de données est diminuée en divisant le bus 18.

Les balayeurs 13 et 13' de lignes de sélection comprennent chacun un étage supplémentaire, respectivement 28 et 28'. Les signaux de sortie des étages 28 et 28' sont connectés au moniteur 22 par les lignes de test respectivement 24 et 24'. Les étages supplémentaires 28 et 28' sont utilisés pour tester le fonctionnement des balayeurs de lignes de sélection respectivement 13 et 13', et pour isoler la dernière ligne de sélection 14 de l'afficheur des lignes de test 24 et 24'. Les balayeurs 13 et 13' de lignes de sélection sont testés séparément avant le test de continuité, le test de court-circuit, et le test du balayeur de lignes de données décrit ici en faisant fonctionner le balayeur de lignes de sélection de manière normale et en regardant le moniteur 22. Un étage défectueux est indiqué par l'absence de signal d'entrée au moniteur 22 venant de la ligne de test 24 du balayeur ayant l'étage défectueux. Des équipements et méthodes séparés tels que décrits dans les demandes de brevet S/N 660274 et S/N 660273, auxquelles il a été fait référence ci-dessus, peuvent être utilisés pour identifier l'étage défectueux.

En fonctionnement, les registres à décalage 19 mettent séquentiellement sous tension les transistors 17 quand le balayeur 11 de lignes de données fournit des signaux de données sur les lignes de données 12. Un seul des TFT 17 est sous tension à la fois dans chaque partie de registre et donc les lignes de données 12 sont couplées en séquence au moniteur 22 par l'intermédiaire des TFT individuels 17 et une partie du bus 18. En conséquence, l'absence de tension sur l'une des lignes de test 21-1 à 21-6 indique un défaut de continuité de l'une des lignes de données 12. La ligne de données défectueuse peut être identifiée avec précision si l'on synchronise le fonctionnement du balayeur 11 de lignes de données et du registre à décalage 19 et si l'on surveille la mise en oeuvre séquentielle des TFT 17. Le moniteur 22 comprend donc, de préférence, du matériel de mesure commandé par ordinateur, qui est de la compétence des spécialistes de la technique. Les étages défectueux du balayeur de lignes de données sont identifiés parce qu'aucun étage après l'étage défectueux ne donne de signal sur une ligne de données 12.

L'existence d'un court-circuit entre une des lignes de données 12 et une des lignes de sélection 14 est détectée en utilisant le balayeur 13 de lignes de sélection pour actionner séquentiellement les lignes de sélection 14 tout en mettant sous tension les TFT 17. Le résultat d'un court-circuit entre une ligne de sélection et une ligne de données est l'application par l'une des lignes de test 21-1 à 21-6 d'une tension au moniteur 22. De même, en synchronisant le balayage des lignes de sélection 14 et en surveillant l'actionnement des TFT 17, l'identité des lignes de données et des lignes de sélection en court-circuit peut être déterminée avec précision.

Le mode de réalisation préférentiel inclut les six lignes de sortie 21, les deux lignes de test 24, 24' et les cinq lignes d'entrée 23-27, treize lignes au total. Ceci est une réduction tres importante du nombre de lignes de test nécessaires pour tester directement les lignes de données 12 séparément, ce qui nécessiterait une ligne de test séparée pour chaque colonne de cellules à cristaux liquides, 1.440 lignes dans l'exemple donné ci-dessus.

## Revendications

1. Circuit de test intégré d'un afficheur à cristaux liquides (10) ayant une matrice de cellules disposées en rangées et colonnes, une pluralité de lignes de données (12) pour appliquer des signaux de données venant d'un balayeur de lignes de données (11) aux colonnes de cellules et une pluralité de lignes de sélection (14) pour appliquer des signaux de sélection venant d'un balayeur de lignes de sélection (13,13') aux rangées de cellules, caractérisé en ce qu'il comporte:
- un bus de sortie (18) ayant au moins une ligne de test (21-1à6),
- une pluralité de dispositifs semi-conducteurs (17) ayant des liaisons conductrices reliant séparément les lignes de données (12) au bus de sortie (18), chacun des dispositifs semi-conducteurs (17) ayant une électrode de commande,
- des moyens (20) pour actionner séquentiellement les électrodes de commande pour transférer lesdits signaux de données des lignes de données (12) à ladite ligne de test (21-1à6),
- et des moyens (22) pour surveiller la ligne de test afin d'identifier les lignes de données (12) ouvertes et les lignes de sélection (14) en court-circuit.

2. Circuit de test selon la revendication 1 caractérisé en ce que le bus de sortie (18) est divisé en une pluralité de segments (18-1à6), chacun de ces segments ayant une ligne de test (21-1à6), et en ce que les moyens (20) pour actionner séquentiellement les électrodes de commande comprennent un registre à décalage (19) divisé en un nombre égal de sections (19-1à6) où chacune des sections actionne l'un des segments (18-1à6).

3. Circuit de test selon la revendication 2 caractérisé en ce que le balayeur de lignes de sélection (13,13') inclut un étage de test (28,28') pour isoler le balayeur de lignes de sélection (13,13') du circuit de test, cet étage de test (28,28') ayant une ligne de sortie de test (24,24') pour vérifier le fonctionnement du balayeur de lignes de sélection (13,13').

4. Circuit de test selon la revendication 3 caractérisé en ce que les dispositifs semi-conducteurs (17) sont des transistors à couches minces.

5. Méthode de test d'un afficheur à cristaux liquides (10) ayant une matrice de cellules disposées en rangées et colonnes, l'afficheur (10) ayant un balayeur de lignes de données (11) pour appliquer les signaux de données à une pluralité de lignes de données (12) qui appliquent individuellement des signaux de données aux colonnes, l'afficheur (10) ayant aussi un balayeur de lignes de sélection (13,13') pour appliquer des signaux de sélection à une pluralité de lignes de sélection (14) qui appliquent séparément des signaux de sélection aux rangées, caractérisée en ce qu'elle est appliquée au dispositif selon une quelconque des revendications précédentes, et qu'elle comporte dans un ordre quelconque les étapes suivantes:
- arrangement de dispositifs semi-conducteurs (17) séparés entre chacune des lignes de données (12) et un bus (18),
- mise en oeuvre séquentielle des dispositifs semi-conducteurs (17) pendant l'application de signaux de données aux lignes de données (12) et surveillance de la tension sur le bus (18) pour identifier les lignes de données (12) ouvertes par l'absence de tension sur le bus (18).
- actionnement séquentiel des dispositifs semi-conducteurs (17) pendant l'application de signaux de sélection aux lignes de sélection (14) tout en surveillant le bus (18) pour détecter l'existence d'un court-circuit par l'existence d'une tension sur le bus (18),
- et fonctionnement de manière normale du balayeur de lignes de données (13,13') afin de détecter un étage défectueux par l'absence de signal sur le moniteur (22).

6. Méthode selon la revendication 5 incluant aussi l'étape de division du bus (18) en une pluralité de segments (18-1à6) et en surveillant séparément les segments (18-1à6).

7. Méthode selon la revendication 6 caractérisée en ce que les dispositifs semi-conducteurs (17) sont des transistors à couches minces.

## Claims

1. Integrated test circuit for a liquid-crystal display (10) having a matrix of cells arranged in rows and columns, a plurality of data lines (12) for applying data signals from a data line scanner (11) to the columns of cells and a plurality of select lines (14) for applying select signals from a select line scanner (13, 13') to the rows of cells, characterized in that it comprises:
- an output bus (18) having at least one test line (21-1 to 6),
- a plurality of semiconductor devices (17) having conducting links individually connecting the data lines (12) to the output bus (18), each of the semiconductor devices (17) having a control electrode,
- means (20) for sequentially actuating the control electrodes in order to transfer the said data signals from the data lines (12) to the said test line (21-1 to 6),
- and means (22) for monitoring the test line so as to identify the open data lines (12) and the shorted select lines (14).

2. Test circuit according to Claim 1, characterized in that the output bus (18) is divided into a plurality of segments (18-1 to 6), each of these segments having a test line (21-1 to 6), and in that the means (20) for sequentially actuating the control electrodes comprise a shift register (19) divided into an equal number of sections (19-1 to 6) in which each of the sections actuates one of the segments (18-1 to 6).

3. Test circuit according to Claim 2, characterized in that the select line scanner (13, 13') includes a test stage (28, 28') for isolating the select line scanner (13, 13') from the test circuit, this test stage (28, 28') having a test output line (24, 24') in order to verify the operation of the select line scanner (13, 13').

4. Test circuit according to Claim 3, characterized in that the semiconductor devices (17) are thin-film transistors.

5. Method for testing a liquid-crystal display (10) having a matrix of cells arranged in rows and columns, the display (10) having a data line scanner (11) in order to apply the data signals to a plurality of data lines (12) which individually apply data signals to the columns, the display (10) also having a select line scanner (13, 13') for applying select signals to a plurality of select lines (14) which individually apply select signals to the rows, characterized in that it is applied to the device according to any one of the preceding claims and in that it comprises, in any order, the following steps:
- arrangement of separate semiconductor devices (17) between each of the data lines (12) and a bus (18),
- sequential operation of the semiconductor devices (17) during application of data signals to the data lines (12) and monitoring of the voltage on the bus (18) in order to identify the open data lines (12) by the absence of voltage on the bus (18),
- sequential actuation of the semiconductor devices (17) during application of select signals to the select lines (14) while monitoring the bus (18) in order to detect the existence of a short by the existence of a voltage on the bus (18),
- and operation, in a normal manner, of the data line scanner (13, 13') so as to detect a defective stage by the absence of a signal on the monitor (22).

6. Method according to Claim 5, which also includes the step of dividing the bus (18) into a plurality of segments (18-1 to 6) and separately monitoring the segments (18-1 to 6).

7. Method according to Claim 6, characterized in that the semiconductor devices (17) are thin-film transistors.

## Patentansprüche

1. Integrierte Testschaltung für ein Flüssigkristallanzeigegerät (10) mit einer Matrix von in Reihen und Spalten angeordneten Zellen, einer Vielzahl von Datenleitungen (12) zum Zuführen von von einem Datenleitungs-Abtaster (11) kommenden Datensignalen zu Spalten von Zellen und einer Vielzahl von Auswahlleitungen (14) zum Anlegen von von einem Auswahlleitungs-Abtaster (13, 13') kommenden Auswahlsignalen an Reihen von Zellen, gekennzeichnet durch:
- einen Ausgangsbus (18) mit wenigstens einer Testleitung (21.1 bis 6),
- eine Vielzahl von Halbleiterelementen (17) mit leitenden Strecken, die getrennt die Datenleitungen (12) mit dem Ausgangsbus (18) verbinden, wobei jede der Halbleiterelemente (17) eine Steuerelektrode aufweist,
- Mittel (20) zum sequentiellen Betätigen der Steuerelektroden zum Übertragen der Datensignale von den Datenleitungen (12) zu der Testleitung (21.1 bis 6)
- und Mittel (22) zum Überwachen der Testleitung zum Identifizieren von unterbrochenen Datenleitungen (12) und kurzgeschlossenen Auswahlleitungen (14).

2. Testschaltung nach Anspruch 1, dadurch gekennzeichnet, daß der Ausgangsbus (18) in mehrere Segmente (18.1 bis 6) aufgeteilt ist, daß jedes der Segmente eine Testleitung (21.1 bis 6) enthält und daß die Mittel (20) zum sequentiellen Betätigen der Steuerelektroden ein Schieberegister (19) enthalten, das in eine Anzahl gleich derjenigen der Abschnitte (19.1 bis 6) aufgeteilt ist, wobei jeder der Bereiche eines der Segmente (18.1 bis 6) betätigt.

3. Testschaltung nach Anspruch 2, dadurch gekennzeichnet, daß der Auswahlleitungs-Abtaster (13, 13') eine Teststufe (28, 28') zum Trennen des Auswahlleitungs-Abtasters (13,13') der Testschaltung enthält, daß diese Teststufe (28,28') eine Test-Ausgangsleitung (24,24') zum Erkennen der Wirkungsweise des Auswahlleitungs-Abtasters (13,13') enthält.

4. Testschaltung nach Anspruch 3, dadurch gekennzeichnet, daß die Halbleiterelemente (17) Dünnschichttransistoren sind.

5. Testverfahren für ein Flüssigkristallanzeigegerät (10) mit einer Matrix von in Reihen und Spalten angeordneten Zellen, wobei das Gerät (10) einen Datenleitungs-Abtaster (11) zum Zuführen von Datensignalen an eine Vielzahl von Datenleitungen (12) enthält, der einzeln Datensignale den Spalten zuführt, wobei das Anzeigegerät (10) außerdem einen Auswahlleitungs-Abtaster (13,13') zum Anlegen von Auswahlsignalen an eine Vielzahl von Auswahlleitungen (14) enthält, der getrennt Auswahlsignale an die Reihen anlegt, dadurch gekennzeichnet, daß es bei einer Vorrichtung nach einem der vorangehenden Ansprüche angewendet wird und daß es in einer beliebigen Reihenfolge die folgenden Schritte enthält:
- Anordnung der getrennten Halbleiterelemente (17) zwischen jeder Datenleitung (12) und einem Bus (18),
- sequentielles Einschalten der Halbleiterelemente (17) während des Anlegens der Datensignale an die Datenleitungen (12) und Überwachung der Spannung auf dem Bus (18) zur Identifizierung von unterbrochenen Datenleitungen (12) durch das Fehlen der Spannung auf dem Bus (18),
- sequentielles Betätigen der Halbleiterelemente (17) während des Anlegens der Auswahlsignale an die Auswahlleitungen (14) und ständiges Überwachen des Bus (18) zum Ermitteln eines Kurzschlusses aufgrund des Auftretens einer Spannung auf dem Bus (18),
- und normale Arbeitsweise des Datenleitungs-Abtasters (13,13'), um eine fehlerhafte Stufe durch das Fehlen des Signals bei dem Monitor (22) zu ermitteln.

6. Verfahren nach Anspruch 5, enthaltend den Schritt einer Aufteilung des Bus (18) in mehrere Segmente (18.1 bis 6) und getrenntes Überwachen der Segmente (18.1 bis 6).

7. Verfahren nach Anspruch 6, dadurch gekennzeichnet, daß die Halbleiterelemente (17) Dünnschichttransistoren sind.
